# EUROPEAN PATENT APPLICATION

(11) **EP 4 566 986 A1**
(43) Date of publication of application: **11.06.2025**
(21) Application number: 23214335.4
(22) Date of filing: 05.12.2023
(51) Int. Cl.: B81C 1/00

(54) **MICROELECTROMECHANICAL COMPONENT WITH A METAL STANDOFF**

(71) Applicant: Murata Manufacturing Co., Ltd., Nagaokakyo-shi, Kyoto 617-8555 (JP)
(72) Inventor: RINKIÖ, Marcus, 05200 Rajamäki (FI); TUOMISTO, Noora, 00340 Helsinki (FI); SALARI, Sareh, 02200 Espoo (FI); BLOMQVIST, Anssi, 00980 Helsinki (FI)
(74) Representative: Boco IP Oy Ab

(57) **Abstract**

The disclosure describes a microelectromechanical component with a metal standoff and a method to manufacture it. The metal standoff provides an accurate control of the MEMS gap height during the eutectic bonging of the component as well as mechanical stress reduction of the electrical contact.

## Description

### FIELD OF THE DISCLOSURE

This disclosure relates to electronic devices and more particularly to Microelectromechanical components. The present disclosure further concerns eutectic bonding of microelectromechanical components with a metal standoff.

### BACKGROUND OF THE DISCLOSURE

Microelectromechanical systems (MEMS) are the technology of microscopic devices which combine mechanical and electrical features. MEMS devices, also called MEMS elements, can have either simple or complex structures with various moving parts. They include devices such as gyroscopes, acceleration sensors, magnetometers, and pressure sensors. MEMS devices may be fabricated from a silicon wafer by microfabrication techniques.

Electronic chips, also called dies, are prepared by manufacturing various electronic structures on a substrate and cutting the substrate into small, chip-size pieces. These chips may be MEMS devices. Several MEMS elements may be built on the same die. This allows significant cost and area reduction. Once the MEMS elements are built, they may need to be sealed in a particular environment depending on their function.

Eutectic bonding, also known as eutectic soldering, is a well-established semiconductor bonding technology that involves bonding wafers together by high pressure using a seal formed of two or more metal films which transform into a eutectic alloy at a specific temperature (eutectic temperature). Due to their easy preparation techniques and good wettability, eutectic alloys form excellent seals in electronic devices. Eutectic bonding is widely used in MEMS technology for the hermetic sealing of MEMS components. During the bonding process, at the eutectic temperature, the eutectic alloy is in liquid phase. Because bonding process involves pressing wafers together at high pressure, in some circumstances, it may be challenging to accurately control the gap height between the bonded wafers, and thus the MEMS element cavity height, due to the softness of the liquid eutectic alloy. The use of standoffs formed of a semiconducting material to control the gap height between eutectically bonded wafers is a known solution. For example, document US10308507B2 discloses a gap control structure in MEMS devices wherein the gap control structure comprises a standoff formed of a semiconducting material. However, it may be challenging to reduce the MEMS element size when such gap control structures are included in MEMS devices.

### BRIEF DESCRIPTION OF THE DISCLOSURE

An object of the present disclosure is to provide a solution to the problem described above.

The disclosed solution allows MEMS vertical gap height control in eutectically bonded microelectromechanical components. Examples provided in this disclosure describe ways to implement the solution. The improvement is achieved by features of the microelectromechanical component and a manufacturing method.

The object of the disclosure is achieved by an arrangement which is characterized by what is stated in the independent claims. The preferred embodiments of the disclosure are disclosed in the dependent claims.

The disclosure is based on the idea of including at least one metal standoff inside the MEMS element. The metal standoff provides an accurate control of the MEMS gap height during the eutectic bonding of the component and enables element size reduction. This provides new improvements of gap control and robustness of the eutectic bond in the microelectromechanical component.

### BRIEF DESCRIPTION OF THE DRAWINGS

In the following, the disclosure will be described in greater detail by means of preferred embodiments with reference to the accompanying drawings, in which
Figure 1a illustrates an example of the sectional view of a microelectromechanical component comprising a metal standoff;
Figure 1b illustrates an example of the sectional view of a microelectromechanical component comprising a plurality of metal standoffs;
Figure 2a illustrates another example of the sectional view of a microelectromechanical component comprising a metal standoff. The electrical connection comprises an electrically conductive via;
Figure 2b illustrates another example of the sectional view of a microelectromechanical component comprising a metal standoff. The cap wafer comprises semiconducting parts and insulating parts;
Figures 3a-b illustrate examples of the sectional view of microelectromechanical components comprising a metal standoff. In these components, the top surface of the structure wafer comprises a protrusion;
Figures 4a-4e provide a simplified illustration of an example method for manufacturing a microelectromechanical component with a metal standoff;
Figures 5a-5d illustrate a few steps in the example method for manufacturing a microelectromechanical component wherein the cap wafer comprises an electrically conductive via;

### DETAILED DESCRIPTION OF THE DISCLOSURE

The disclosure describes a microelectromechanical component comprising a cap wafer and a structure wafer. The cap wafer has a top surface and a bottom surface, and the top surface of the cap wafer defines a horizontal xy-plane and a vertical z-direction which is perpendicular to the xy-plane. The structure wafer has a top surface and a bottom surface. The cap wafer and the structure wafer are bonded to each other so that the cap wafer and the structure wafer are aligned with each other in the z-direction. The microelectromechanical component further comprises an electrical connection and a gap-control region, and the electrical connection is in the gap-control region. The electrical connection comprises a metal layer. The metal layer extends in the z-direction from the bottom surface of the cap wafer to the top surface of the structure wafer. The microelectromechanical component further comprises one or more metal standoffs, and the one or more metal standoffs are located at the bottom surface of the cap wafer in the gap-control region. The one or more metal standoffs are adjacent to the electrical connection and extend in the z-direction from the bottom surface of the cap wafer to the top surface of the structure wafer. The compressive strength of the metal forming the one or more metal standoffs is greater than the compressive strength of the metal layer in the electrical connection.

Any direction or plane which is parallel to the xy-plane defined by the cap wafer can be called horizontal. The direction which is perpendicular to the xy-plane can be called vertical direction. Expressions such as "top", "bottom", "above", "below", "up" and "down" refer in this disclosure to differences in the vertical z-coordinate. These expressions do not imply anything about how the device should be oriented with respect to the earth's gravitational field when the component is in use or when it is being manufactured.

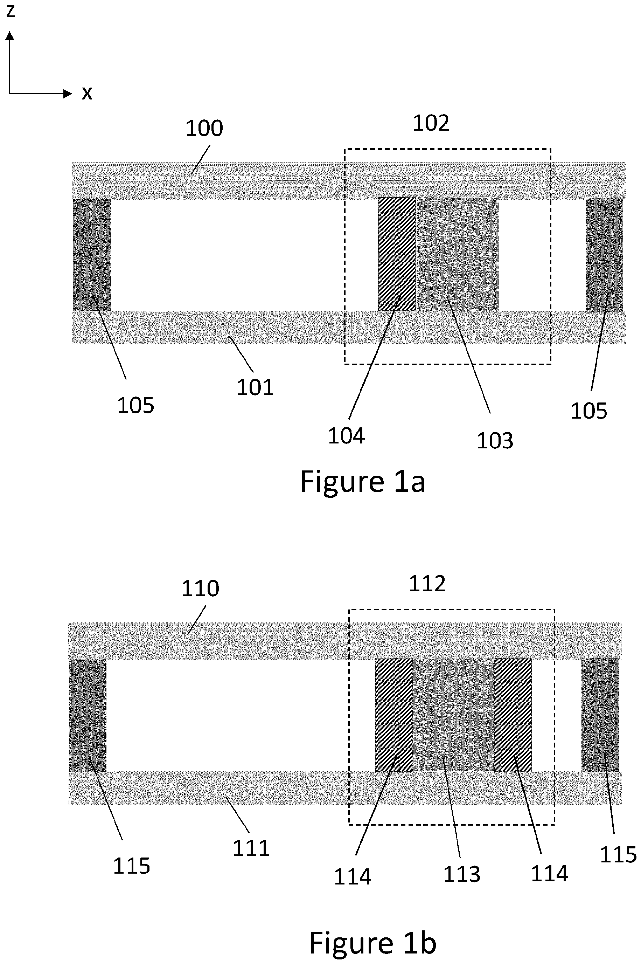

Figure 1a illustrates an example of the sectional view of a microelectromechanical component comprising a metal standoff 104. In this example, the cap wafer 100 and the structure wafer 101 are bonded to each other via a seal 105 so that the cap wafer and the structure wafer are aligned with each other in the z-direction. The seal 105 may be a eutectic seal which is formed by two or more metals or by a combination of one or more metals and a metalloid which transform into a eutectic alloy at a specific temperature. The microelectromechanical component further comprises a gap-control region 102 and an electrical connection located in the gap-control region 102. The electrical connection may connect the cap wafer to the structure wafer. This connection may for example connect electrical signals and/or electrical potentials between the micromechanical structure and system electronics. In this example, the electrical connection comprises a metal layer 103. The metal layer 103 is attached to the bottom surface of the cap wafer 100 and extends in the z-direction from the bottom surface of the cap wafer 100 to the top surface of the structure wafer 101. The microelectromechanical component further comprises a metal standoff 104. The metal standoff 104 is attached to the bottom surface of the cap wafer 100 in the gap-control region 102. The metal standoff 104 is adjacent to the metal layer 103 and extends in the z-direction from the bottom surface of the cap wafer 100 to the top surface the structure wafer 101. In this example, the metal standoff 104 is in contact with the metal layer 103. Alternatively, the metal standoff may be beside the metal layer. This option may apply to any embodiment in this disclosure. The surface area of the metal standoff in the xy-plane may be of the same order of magnitude or larger than the surface of metal layer 103 in the xy-plane.

In any embodiment presented in this disclosure, the one or more metal standoffs may comprise Ti, or the one or more metal standoffs may comprise W. For example, the metal standoff 104 may be made of one or more metals that include but are not limited to Ti, W, Cr, V, or hard metal alloys, or hard metalloid. The metal layer 103 in the electrical connection may be made of one or more metals that include but are not limited to Al, Au, Ag, Cu, Sn, or soft metal alloys. These options may apply to any embodiment in this disclosure. The compressive strength of the one or more metals forming the metal standoff 104 is greater than the compressive strength of the one or more metals forming the metal layer 103. In other words, the one or more metals composing the metal layer 103 are softer than the one or more metals composing the metal standoff 104. These options may apply to any embodiment in this disclosure. The metal standoff may be formed by a variety of deposition methods such as sputtering, chemical vapor deposition, molecular beam epitaxy, electron beam physical vapor evaporation, atomic layer deposition, or laser metal deposition. The metal layer may be formed by a variety of deposition methods such as sputtering, chemical vapor deposition, molecular beam epitaxy, electron beam physical vapor evaporation, atomic layer deposition, or laser metal deposition. These options may apply to any embodiment in this disclosure. While the metal layer may serve as an ohmic contact in the MEMS, due to its hardness, the metal standoff provides an accurate control of the MEMS gap height during the eutectic bonding of the component, mechanical stress reduction of the electrical contact, as well as the possibility for element size reduction.

The microelectromechanical component may comprise a plurality of metal standoffs. The metal standoffs may be substantially evenly distributed around the metal layer. Figure 1b illustrates an example of the sectional view of a microelectromechanical component comprising a plurality of metal standoffs. In this example, the electrical connection comprises a metal layer 113. The metal layer 113 is attached to the bottom surface of the cap wafer 110 in the gap-control region 112 and extends in the z-direction from the bottom surface of the cap wafer 110 to the top surface of the structure wafer 111. The microelectromechanical component further comprises two metal standoffs 114 in the gap-control region 112. The metal standoffs 114, which are both adjacent to the metal layer 113, are opposite to each other on different sides of the metal layer 113. The metal standoffs 114 are attached to the bottom surface of the cap wafer 110 and extend in the z-direction from the bottom surface of the cap wafer 110 to the top surface the structure wafer 111. Reference number 115 in figure 1b corresponds to reference numbers 105 in figure 1a.

The cap wafer may be a semiconducting wafer, or an insulating wafer such as a glass layer, or a wafer comprising semiconducting parts and insulating parts, or a wafer comprising metal parts and insulating parts, or integrated circuitry (IC). The insulating parts may be made of glass or other insulating materials such as silicon dioxide, silicon nitride or aluminium oxide. These options may apply to any embodiment in this disclosure.

The structure wafer may be a semiconductor device layer which has been attached to a support layer (not illustrated). The device layer may be a layer of silicon. The device layer and the support layer may for example be parts of a silicon-on-insulator (SOI) substrate where MEMS elements can be formed by patterning the top silicon layer (the device layer). These options may apply to any embodiment in this disclosure.

The electrical connection may further comprise an electrically conductive via. The electrically conductive via may extend along the z-direction through the cap wafer, and the metal layer may extend along the bottom surface of the cap wafer so that it meets the electrically conductive via. The electrically conductive via may extend through a portion of the cap wafer thickness. Alternatively, the electrically conductive via may extend through the whole cap wafer thickness.

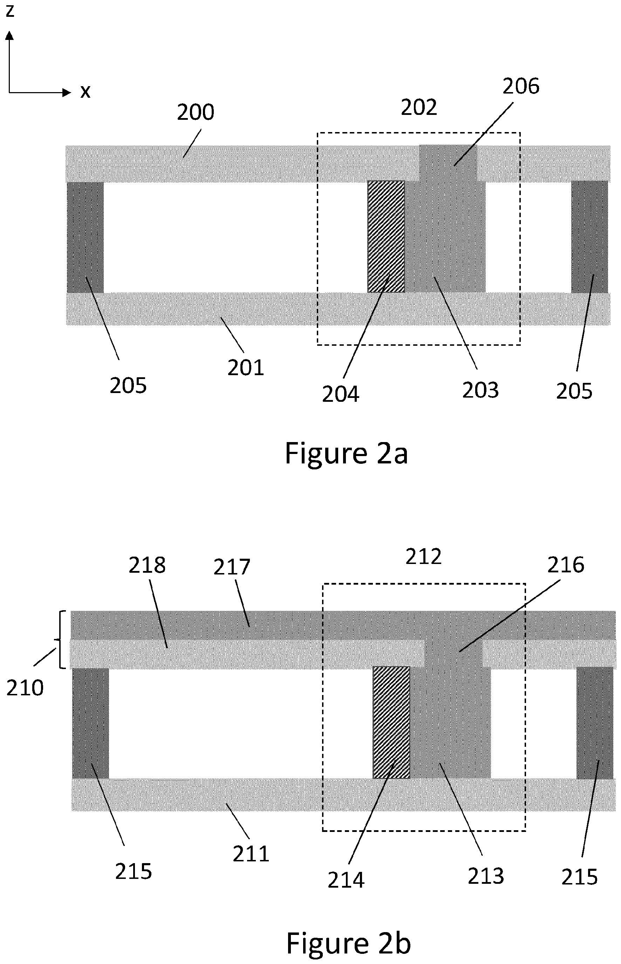

Figure 2a illustrates another example of the sectional view of the microelectromechanical component comprising a metal standoff. The cap wafer 200 and the structure wafer 201 are bonded to each other via a seal 205 so that the cap wafer and the structure wafer are aligned with each other in the z-direction. The microelectromechanical component further comprises a gap-control region 202 and an electrical connection in the gap-control region. In this example, the electrical connection comprises a metal layer 203 and an electrically conductive via 206. The electrically conductive via 206 extends along the z-direction through the cap wafer thickness. The metal layer 203 extends in the x-direction along the bottom surface of the cap wafer so that it meets the electrically conductive via 206 and extends along the z-direction from the bottom surface of the cap wafer 200 to the top surface of the structure wafer 201. The metal layer 203 may be connected to an external electrical connection through the electrically conductive via 206. The cap wafer may be an insulating wafer such as a glass wafer. The electrically conductive via may comprise a semiconducting material such as Si. Alternatively, the electrically conductive via may comprise a metal such as Al, Au, Ag, Cu, Sn, or a metal alloy. The electrically conductive via and the metal layer may be made of the same metal. Alternatively, the electrically conductive via and the metal layer may be made of different metals. These options may apply to any embodiment in this disclosure. The microelectromechanical component further comprises a metal standoff 204 in the gap-control region, wherein the metal standoff 204 is adjacent to the metal layer 203. The metal standoff 204 is attached to the bottom surface of the cap wafer and extends in the z-direction from the bottom surface of the cap wafer 200 to the top surface the structure wafer 201.

The cap wafer may comprise a semiconducting part and an insulating part, wherein the semiconducting part is located on top of the insulating part so that the bottom surface of the insulating part forms the bottom surface of the cap wafer. Alternatively, the cap wafer may comprise a conductive part, such as a metal part, and an insulating part, wherein the metal part is located on top of the insulating part so that the bottom surface of the insulating part forms the bottom surface of the cap wafer. Figure 2b illustrates an example of the sectional view of a microelectromechanical component comprising a metal standoff. The microelectromechanical component comprises a cap wafer 210 and a structure wafer 211 which are bonded together via a seal 215. In this example, the cap wafer comprises a semiconducting part 217 and an insulating part 218. The semiconducting part 217 is located on top of the insulating part 218. The microelectromechanical component further comprises an electrical connection in the gap-control region 212. The electrical connection comprises an electrically conductive via 216, and the electrically conductive via 216 extends along the z-axis from the bottom side of the semiconducting part 217 to the bottom side of the insulating part 218 so that the insulating part surrounds the sides of the electrically conductive via 216. Reference numbers 213 and 214 in figure 2b correspond to reference numbers 203 and 204, respectively, in figure 2a.

The top surface of the structure wafer may comprise a protrusion wherein the protrusion is located in the gap-control region. The metal layer may extend from the bottom surface of the cap wafer to the protrusion, and the one or more metal standoffs may extend in the z-direction from the bottom surface of the cap wafer to the protrusion. The metal layer and the protrusion, which acts as an anchor, may serve as a good ohmic press-on contact inside the element. The protrusion may have different shapes such as a truncated pyramid shape, or a pillar-like shape. The pillar like-shape may be, but is not limited to, a cylinder, a hexagonal prism, or a cuboid. These options may apply to any embodiment in this disclosure.

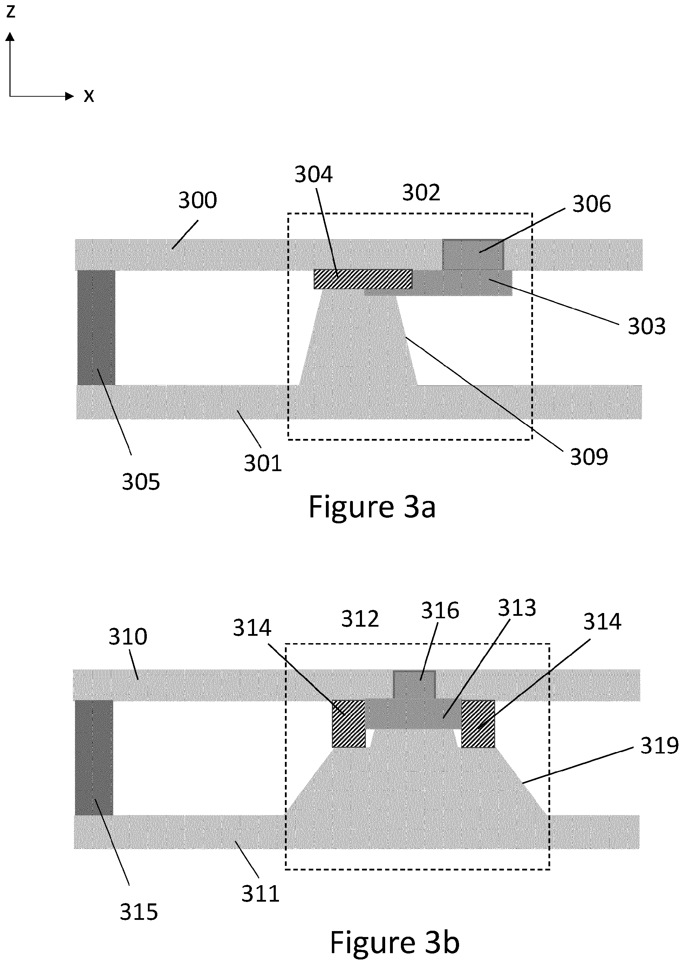

Figure 3a illustrates another example of the sectional view of a microelectromechanical component comprising a metal standoff. The cap wafer 300 and the structure wafer 301 are bonded together via a seal 305. The microelectromechanical component comprises an electrical connection, and the electrical connection comprises an electrically conductive via 306 and a metal layer 303. In this example, the electrically conductive via 306 extends along the z-axis through the cap wafer thickness, and the metal layer 303 extends in the x-direction along the bottom surface of the cap wafer so that it meets the bottom side of the electrically conductive via 306. The microelectromechanical component further comprises a metal standoff 304 which is adjacent to the metal layer 303. In this example, the metal layer 303 overlaps the metal standoff 304. In other words, the metal layer 303 extends in the x-direction so that it covers a portion of the metal standoff 304. The compressive strength of the one or more metals forming the metal standoff 304 is greater than the compressive strength of the one or more metals forming the metal layer 303. The top surface of the structure wafer 301 comprises a protrusion 309 in the gap-control region 302. The protrusion 309 bulges out in the z-direction so that it meets the metal standoff 304 and the metal layer 303. The protrusion may be formed by semiconductor microfabrication techniques such as LOCOS process, wet etching process or dry etching process. These options may apply to any embodiment in this disclosure.

Figure 3b illustrates another example of the sectional view of a microelectromechanical component with metal standoffs. In this example, the electrical connection comprises an electrically conductive via 316 and a metal layer 313. The electrically conductive via 316 extends along the z-axis through the cap wafer thickness, and the metal layer 313 extends along the bottom surface of the cap wafer 310 so that it meets the bottom side of the electrically conductive via 316. The top surface of the structure wafer 311 comprises a protrusion 319 in the gap-control region 312. In this example, the protrusion 319 has a multi-height step-pyramid-like shape. The step-pyramid comprises a summit and side steps. The distance in the z-direction from the bottom surface of the cap wafer to the summit is less than the distance in the z-direction from bottom surface of the cap wafer to the side steps. The protrusion 319 extends in the z-direction so that its summit meets the metal layer 313. The microelectromechanical component further comprises two metal standoffs 314 which are adjacent to the metal layer 313 and are located opposite to each other on different sides of the metal layer 313. The metal standoffs 314 extend along the z-direction from the bottom surface of the cap wafer to the protrusion so that the bottom of each metal standoff is in contact with a side step. The compressive strength of the one or more metals forming the metal standoffs 314 is greater than the compressive strength of the one or more metals forming the metal layer 313 in the electrical connection. Reference number 315 in figure 3b corresponds to reference number 305 in figure 3a.

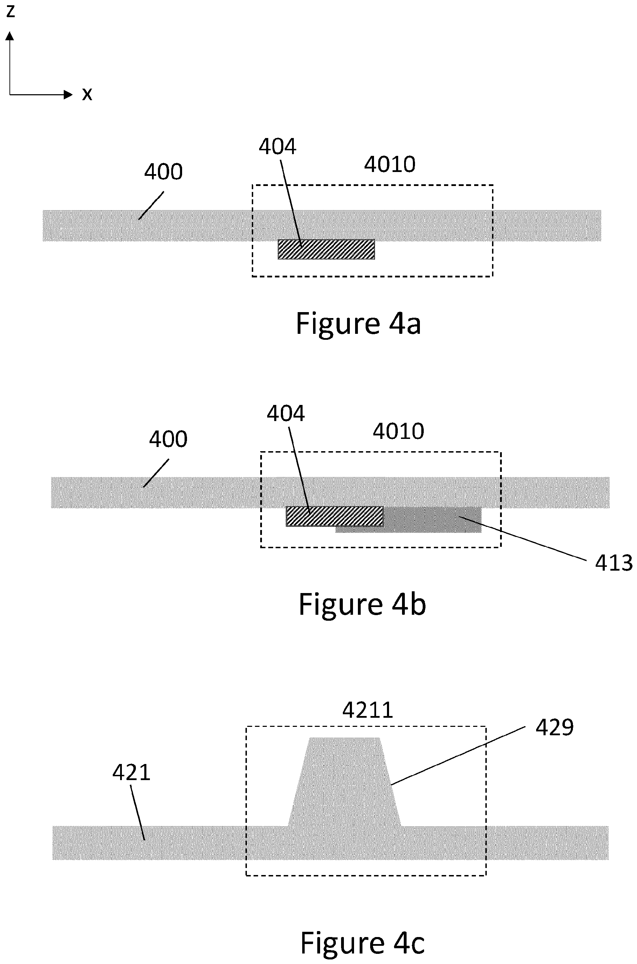

Figures 4a-4e provide a simplified illustration of an example method for manufacturing a microelectromechanical component with a metal standoff. The microelectromechanical element comprises a cap wafer and a structure wafer. The cap wafer has a top surface and a bottom surface, and the top surface of the cap wafer defines a horizontal xy-plane and a vertical z-direction which is perpendicular to the xy-plane. The cap wafer comprises a cap wafer gap-control region. The structure wafer has a top surface and a bottom surface. The structure wafer comprises a structure wafer gap-control region.

The method comprises: (1) forming one or more metal standoffs at the bottom surface of the cap wafer in the cap wafer gap-control region, (2) forming a metal layer on the bottom surface of the cap wafer in the cap wafer gap-control region so that the metal layer is adjacent to the one or more metal standoffs, (3) placing the cap wafer on top of the structure wafer so that the cap wafer gap-control region is aligned with the structure wafer gap-control region in the z-direction, (4) bonding the cap wafer and the structure wafer together so that the metal layer extends in the z-direction from the bottom surface of the cap wafer to the top surface of the structure wafer and the one or more metal standoffs extend in the z-direction from the bottom surface of the cap wafer to the top surface of the structure wafer. The compressive strength of the metal forming the one or more metal standoffs is greater than the compressive strength of the metal layer in the electrical connection. The components described above may include any structural feature which is included in the following presentation of manufacturing method.

The structure wafer may be a semiconductor device layer which has been attached to a support layer. The device layer may be a layer of silicon. The device layer and the support layer may for example be parts of a silicon-on-insulator (SOI) substrate where MEMS elements can be formed by patterning the top silicon layer (the device layer).

The cap wafer may be a semiconducting wafer, or an insulating wafer such as a glass layer, or a wafer comprising semiconducting parts and insulating parts, or a wafer comprising metal parts and insulating parts or integrated circuitry (IC). The insulating parts may be made of glass or other insulating materials such as silicon dioxide, silicon nitride or aluminium oxide.

Figure 4a illustrates one of the first steps in the example method for manufacturing a microelectromechanical component with a metal standoff. This step comprises forming a metal standoff 404 at the bottom surface of the cap wafer 400 in the cap wafer gap-control region 4010.

Figure 4b illustrates another step in the example method for manufacturing a microelectromechanical component with a metal standoff. This step comprises forming a metal layer 413 on the bottom surface of the cap wafer 400 in the cap wafer gap-control region 4010, so that the metal layer 413 is adjacent to the metal standoff 404. In this example, the metal layer 413 overlaps the metal standoff 404. In other words, the metal layer 413 extends in the x-direction so that it covers partly the bottom surface of the metal standoff 404.

The compressive strength of the one or more metals forming the metal standoff 404 is greater than the compressive strength of the one or more metals forming the metal layer 413. In other words, the metal layer is more malleable than the metal standoff. The metal standoff provides an accurate control of the MEMS gap height during the eutectic bonging of the component.

The method may comprise forming a protrusion in the structure wafer gap-control region before placing the cap wafer on top of the structure wafer so that the top surface of the structure wafer comprises the protrusion.

Figure 4c illustrates the step of forming a protrusion 429 in the structure wafer gap-control region 4211 so that the top surface of the structure wafer 421 comprises the protrusion 429. The protrusion 429 bulges upward and is aligned with the metal standoff 404 and the metal layer 413 in the z-direction. The protrusion 429 may be formed by semiconductor microfabrication techniques such as LOCOS process, wet etching process or dry etching process. These options may apply to any embodiment in this disclosure.

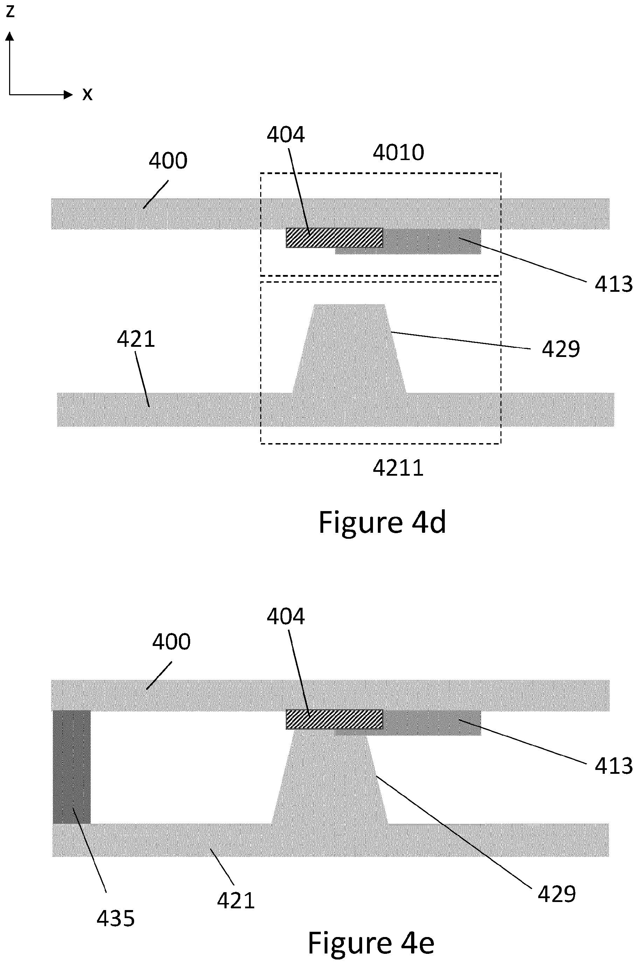

Figure 4d illustrates a further step in the example method for manufacturing a microelectromechanical component with a metal standoff. This step comprises placing the cap wafer 400 on top of the structure wafer 421 so that the cap wafer gap-control region 4010 is aligned with the structure wafer gap-control region 4211 in the z-direction. In this example, the protrusion 429 is aligned with the metal standoff 404 and the metal layer 413 in the z-direction.

Figure 4e illustrates the final step in the example method for manufacturing a microelectromechanical component with a metal standoff. This step comprises bonding the cap wafer 400 and the structure wafer 421 together so that the metal layer 413 extends in the z-direction from the bottom surface of the cap wafer 400 to the top surface of the structure wafer 421 and the one or more metal standoffs 404 extend in the z-direction from the bottom surface of the cap wafer 400 to the top surface of the structure wafer 421. In this example, the metal layer 413 and the metal standoff 404 extend in the z-direction from the bottom surface of the cap wafer 400 to the protrusion 429. The cap wafer 400 and the structure wafer 421 may be eutectically bonded together via a eutectic seal 435.

The method for manufacturing a microelectromechanical component may comprise the step of forming an electrically conductive via in the cap wafer gap-control region before forming the one or more metal standoffs at the bottom surface of the cap wafer. The electrically conductive via may extend along the z-direction through the cap wafer and the metal layer may meet the bottom of the electrically conductive via. The electrically conductive via may extend through a portion of the cap wafer thickness. Alternatively, the electrically conductive via may extend through the whole cap wafer thickness.

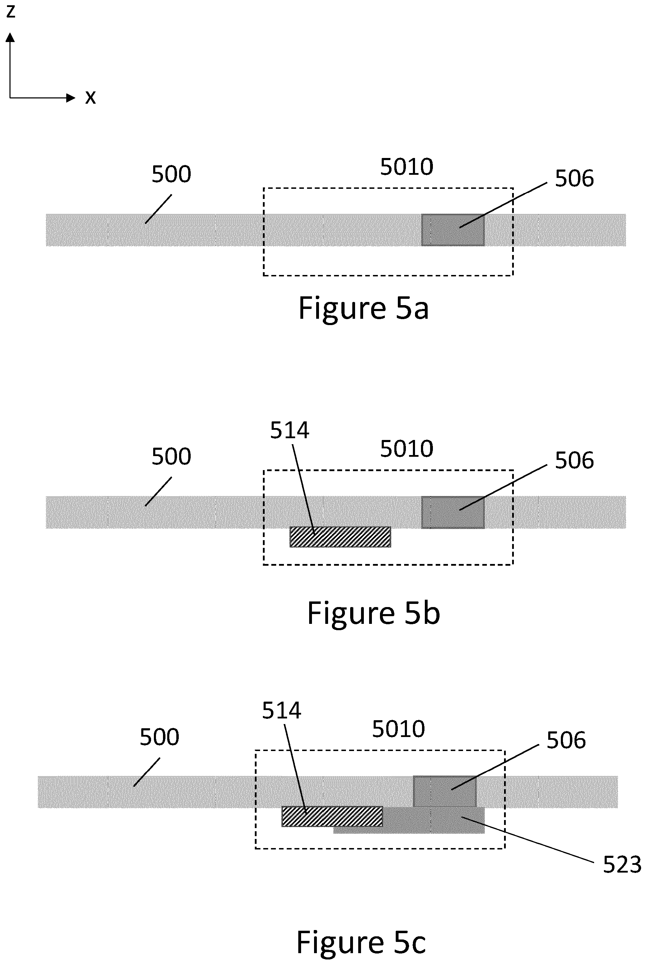

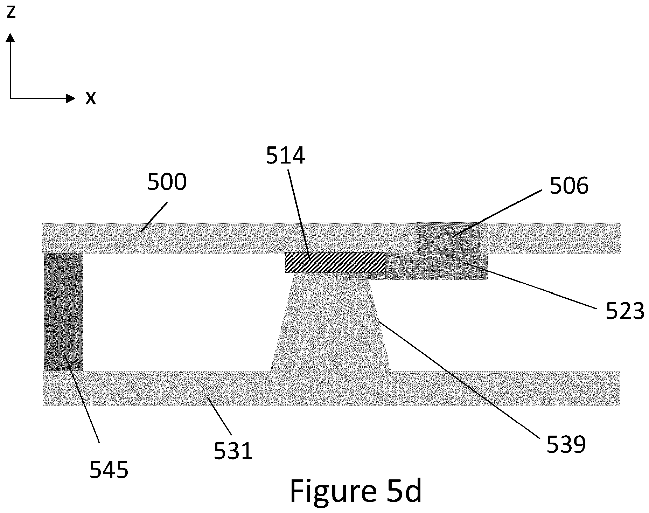

Figures 5a-5d illustrate a few steps in the example method for manufacturing a microelectromechanical component wherein the cap wafer comprises an electrically conductive via. Figure 5 a illustrates the step of forming an electrically conductive via 506 in the cap wafer gap-control region 5010 before forming the one or more standoffs. The electrically conductive via extends along the z-direction through the cap wafer 500. In this example, the cap wafer may be an insulating wafer such as a glass layer. The electrically conductive via 506 may comprise a semiconducting material. Alternatively, the electrically conductive via may comprise a metal. These options may apply to any embodiment in this disclosure.

Figure 5b illustrates a further step in the example method for manufacturing a microelectromechanical component with a metal standoff. This step comprises forming a metal standoff 514 at the bottom surface of the cap wafer 500 in the cap wafer gap-control region 5010.

Figure 5c illustrates another step in the example method for manufacturing a microelectromechanical component with a metal standoff. This step comprises forming a metal layer 523 on the bottom surface of the cap wafer 500 in the cap wafer gap-control region 5010, so that the metal layer 523 is adjacent to the metal standoff 514 and that the metal layer 523 meets the electrically conductive via 506. The metal layer 523 extends in the x-direction so that it covers partly the bottom surface of the metal standoff 514.

Figure 5d illustrates the final step in the example method for manufacturing a microelectromechanical component with a metal standoff. This step comprises bonding the cap wafer 500 and the structure wafer 531 together so that the metal layer 523 extends in the z-direction from the bottom surface of the cap wafer 500 to the top surface of the structure wafer 531 and the metal standoff 514 extends in the z-direction from the bottom surface of the cap wafer 500 to the top surface of the structure wafer 531. In this example, the metal layer 523 and the metal standoff 514 extend from the bottom surface of the cap wafer 500 to the protrusion 539. Reference number 545 in figure 5c corresponds to reference number 435 in figure 4e.

## Claims

1. A microelectromechanical component comprising a cap wafer and a structure wafer,
wherein the cap wafer has a top surface and a bottom surface, and the top surface of the cap wafer defines a horizontal xy-plane and a vertical z-direction which is perpendicular to the xy-plane,
and wherein the structure wafer has a top surface and a bottom surface,
and wherein the cap wafer and the structure wafer are bonded to each other so that the cap wafer and the structure wafer are aligned with each other in the z-direction,
**Characterized in that**
the microelectromechanical component further comprises an electrical connection and a gap-control region, and the electrical connection is in the gap-control region, and wherein the electrical connection comprises a metal layer, and the metal layer extends in the z-direction from the bottom surface of the cap wafer to the top surface of the structure wafer,
and wherein the microelectromechanical component further comprises one or more metal standoffs and the one or more metal standoffs are located at the bottom surface of the cap wafer in the gap-control region, and wherein the one or more metal standoffs are adjacent to the electrical connection and extend in the z-direction from the bottom surface of the cap wafer to the top surface of the structure wafer, and wherein the compressive strength of the metal forming the one or more metal standoffs is greater than the compressive strength of the metal layer in the electrical connection.

2. A microelectromechanical component according to claim 1, wherein the one or more metal standoffs comprise Ti.

3. A microelectromechanical component according to claim 1, wherein the one or more metal standoffs comprise W.

4. A microelectromechanical component according to any of the previous claims wherein the electrical connection further comprises an electrically conductive via, and the electrically conductive via extends along the z-direction through the cap wafer, and wherein the metal layer extends along the bottom surface of the cap wafer so that it meets the electrically conductive via.

5. A microelectromechanical component according to claim 4, wherein the electrically conductive via comprises a semiconducting material.

6. A microelectromechanical component according to claim 4, wherein the electrically conductive via comprises a metal.

7. A microelectromechanical component according to any of the previous claims, wherein the top surface of the structure wafer comprises a protrusion, and wherein the protrusion is located in the gap-control region, and wherein the metal layer extends from the bottom surface of the cap wafer to the protrusion and the one or more metal standoffs extend in the z-direction from the bottom surface of the cap wafer to the protrusion.

8. A method for manufacturing a microelectromechanical element with a metal standoff, wherein the microelectromechanical element comprises a cap wafer and a structure wafer,
and wherein the cap wafer has a top surface and a bottom surface, and the top surface of the cap wafer defines a horizontal xy-plane and a vertical z-direction which is perpendicular to the xy-plane, and wherein the cap wafer comprises a cap wafer gap-control region,
and wherein the structure wafer has a top surface and a bottom surface, and wherein the structure wafer comprises a structure wafer gap-control region,
**Characterized in that** the method comprises:
- Forming one or more metal standoffs at the bottom surface of the cap wafer in the cap wafer gap-control region,
- Forming a metal layer on the bottom surface of the cap wafer in the cap wafer gap-control region so that the metal layer is adjacent to the one or more metal standoffs,
- Placing the cap wafer on top of the structure wafer so that the cap wafer gap-control region is aligned with the structure wafer gap-control region in the z-direction,
- Bonding the cap wafer and the structure wafer together so that the metal layer extends in the z-direction from the bottom surface of the cap wafer to the top surface of the structure wafer and the one or more metal standoffs extend in the z-direction from the bottom surface of the cap wafer to the top surface of the structure wafer,
and wherein the compressive strength of the metal forming the one or more metal standoffs is greater than the compressive strength of the metal layer in the electrical connection.

9. A method for manufacturing a microelectromechanical component according to claim 8, wherein the method further comprises forming a protrusion in the structure wafer gap-control region before placing the cap wafer on top of the structure wafer so that the top surface of the structure wafer comprises the protrusion.

10. A method for manufacturing a microelectromechanical component according to claims 8-9, wherein the method comprises the step of forming an electrically conductive via in the cap wafer gap-control region before forming the one or more metal standoffs at the bottom surface of the cap wafer, wherein the electrically conductive via extends along the z-direction through the cap wafer, and wherein the metal layer meets the bottom of the electrically conductive via.

11. A method for manufacturing a microelectromechanical component according to claim 10, wherein the electrically conductive via comprises a semiconducting material.

12. A method for manufacturing a microelectromechanical component according to claim 10, wherein the electrically conductive via comprises a metal.
